## Europäisches Patentamt
## European Patent Office
## Office européen des brevets

(19)

(11) Publication number: **0 023 419**
**B1**

(12)
# EUROPEAN PATENT SPECIFICATION

(45) Date of publication of patent specification: **11.04.84**

(51) Int. Cl.³: **G 01 R 31/28**

(21) Application number: **80302531.1**

(22) Date of filing: **24.07.80**

(54) **A method and a device for testing a logic circuit.**

(30) Priority: **26.07.79 JP 94198/79**

(43) Date of publication of application:
**04.02.81 Bulletin 81/5**

(45) Publication of the grant of the patent:
**11.04.84 Bulletin 84/15**

(84) Designated Contracting States:
**DE FR GB NL**

(56) References cited:
**DE - A - 2 812 344**
**DE - A - 2 902 375**

(73) Proprietor: **FUJITSU LIMITED**
**1015, Kamikodanaka Nakahara-ku**
**Kawasaki-shi Kanagawa 211 (JP)**

(72) Inventor: **Hatano, Yoshinori**
**5-12-3-203 chuoh Nakano-ku**
**Tokyo 164 (JP)**
Inventor: **Wada, Kiyoshi**
**2807 Nogawa Takatsu-ku**
**Kawasaki-shi Kanagawa 213 (JP)**
Inventor: **Midorikawa, Ichiro**
**1-54-10 Kitasenzoku Ohta-ku**
**Tokyo 145 (JP)**

(74) Representative: **Rackham, Stephen Neil et al,**
**GILL JENNINGS & EVERY 53-64 Chancery Lane**
**London WC2A 1HN (GB)**

Courier Press, Leamington Spa, England.

## A method and a device for testing a logic circuit

The present invention relates to a testing system for testing a logic circuit and, more particularly, to a method and a device for testing a logic circuit such as an LSI (which is an abbreviation of Large Scale Integration) logic circuit.

In general, an LSI logic circuit comprises a plurality of flip-flops and a combination circuit including AND gates, OR gates, and inverters. In recent years, to perform a test on such a logic circuit, a scanning system has been suggested. In the scanning system, the flip-flops in the circuit are arranged in parallel so that they serve as registers. A signal path which is called a scanning path is formed between scanning-in and scanning-out terminals of the circuit. The scanning path is connected to one of the flip-flops at any instant by an addressing means. The scanning path is moved to each of the flip-flops one after another in an ordered sequence by the addressing means.

In the testing of such a logic circuit the testing of the flip-flops and the combination circuit are performed separately. The testing of the flip-flops may be performed by supplying input data from the scanning-in terminal to one of the flip-flops, obtaining output data therefrom at the scanning-out terminal and checking whether or not the output data is the same as the input data, and this is a simple operation. Contrary to this, the testing of the combination circuit is a complex operation.

In the past, the combination circuit of a logic circuit is tested by using the flip-flops of the circuit which have already been tested. Firstly, input test data is in sequence set into the flip-flops of the logic circuit by a testing device. After that, the combination circuit executes a logic operation upon the data stored in the flip-flops and the result is again stored in the flip-flops. Next, the results are output as output data, in sequence, from the flip-flops to the testing device. After that, in the testing device, the output data is compared with predetermined data. Thus, testing of the combination circuit is completed.

However, in the above-mentioned prior system, to set the input data into the flip-flops, a large number of input test patterns are required and each of these patterns includes an address code designating one of the flip-flops, input data, and a clock code or the like. Each flip-flop requires its own test pattern. Similarly, to obtain the operation result from the flip-flops, a large number of output test patterns are required, again one for each flip-flop and each also includes an address code designating one of the flip-flops, output data, and a clock code or the like. In this case, the number of input test patterns or output test patterns are the same as that of the flip-flops. As a result, the capacity of memory devices, such as magnetic tapes, for storing the test patterns must be large. In addition, the number of transmissions of test patterns between the testing device and the logic circuit is large, so that a long time is required to perform the test.

According to a first aspect of this invention, a method for testing by means of test data a logic circuit which includes a plurality of flop-flops associated with a scanning path between scanning-in and scanning-out terminals thereof and a combination circuit including logic gates, comprises the steps of:

loading input data forming the test data in parallel into a separate shift register;
reading out the input data from the shift register to the scanning-in terminal in serial form;
sequentially setting the bits of the input data in serial form in each of the flip-flops, respectively;
performing a logic operation upon the input data set in the flip-flops by applying these data to the combination circuit and providing, as a result, output data;
setting the output data resulting from the logic operation in the flip-flops in parallel;
sequentially feeding back the output data of the flip-flops from the scanning-out terminal in serial form to the shift register; and
outputting the output data in parallel form from the shift register.

According to a second aspect of this invention, a device for testing by means of test data a logic circuit which includes a plurality of first flip-flops associated with a scanning path between scanning-in and scanning-out terminals of the logic circuit and a combination circuit including logic gates, comprises

an addressing means for sequentially selecting each of the first flip-flops and is characterised by a shift register connected to the scanning-in and scanning-out terminals, said shift register being adapted (i) to receive input data forming said test data in parallel, (ii) to transmit sequentially the bits of the input data in serial from through the scanning-in terminal to each selected one of the first flip-flops, (iii) to receive sequentially through the scanning-out terminal output data set into the first flip-flops by the combination circuit, the output data resulting from the operation of the combination circuit on the input data previously stored in each selected one of the first flip-flops, and (iv) to output the output data;
in parallel form, the shift register comprising a plurality of second flip-flops connected in series, the number of which is the same as the number of the first flip-flops of the logic circuit; and,

means for controlling the addressing means and the shift register, the controlling means generating:

a clear signal for clearing the addressing means;

a parallel input indicating signal for inputting the input data in parallel to the shift register;

a scanning-in clock signal for transmitting one of the input data bits stored in a high order one of the second flip-flops to a selected one of the first flip-flops;

a shifting/counting signal for shifting the shift register and advancing the addressing means;

a clock signal for setting the operation result of the combination circuit in the first flip-flops in parallel; and,

a scanning end signal for indicating an end of test operation.

An example of a method and a device in accordance with this invention will now be described and contrasted with the prior art with reference to the accompanying drawings; in which:—

Figure 1 is a block diagram illustrating a conventional testing system for a logic circuit;

Figure 2 is a diagram showing test patterns used in the conventional system;

Figure 3 is a block diagram illustrating an example of a testing system in accordance with the present invention;

Figure 4 is a diagram showing a test pattern used in the example in accordance with this invention;

Figure 5 is a circuit diagram of the logic circuit and the testing device in the example in accordance with this invention; and,

Figures 6A to 6G are timing diagrams of the signals "a" to "g", respectively, appearing in the circuit shown in Figure 5.

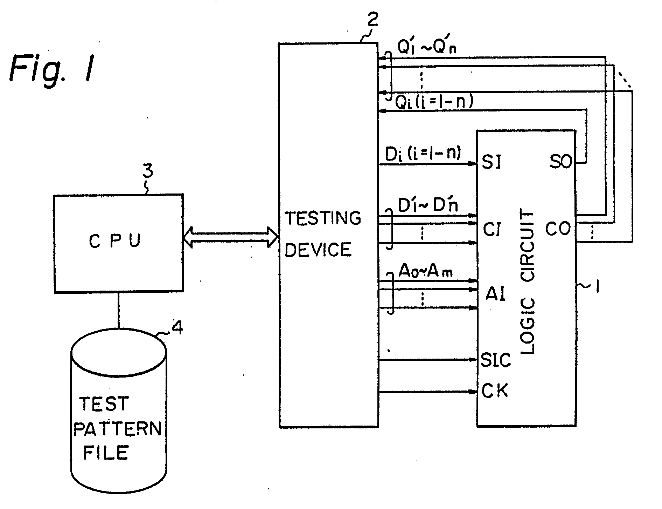

Referring to Figure 1, which illustrates a conventional testing device for a logic circuit, a logic circuit 1 is tested by a testing device 2 which is controlled by a central processing unit (hereinafter referred to as a CPU) 3.

The CPU 3 is associated with a test pattern file 4, which is used for testing the logic circuit 1 and is, for example, formed by magnetic tapes.

The logic circuit 1 comprises n flip-flips (not shown) which serve as registers during a test mode and a combination circuit (not shown) including AND gates, OR gates, inverters or the like. In addition, the logic circuit 1 comprises a scanning-in terminal SI for inputting data $D_i$ ($i = 1, 2, ..., n$) into the i-th flip-flop, circuit input terminal CI for inputting constant data $D'_1$ through $D'_n$ into the combination circuit, address input terminals AI for inputting address signals $A_0$ through $A_m$ so as to select one of the flip-flops, a scanning-in clock terminal SIC for inputting a timing clock for an input operation of the data $D_i$, a clock terminal CK for inputting a timing clock cor setting a logic operation result of the combination circuit in the flip-flops in parallel, a scanning-out terminal SO four outputting the operation results $Q_i$ stored in the flip-flops, and circuit output terminals CO for outputting constant data $Q'_1$ through $Q'_n$.

In order to execute a test for the logic circuit 1, each input data $D_1$ through $D_n$ is set in each of the flip-flops $FF_1$, $FF_2$, ..., $FF_n$ thereof, respectively. For example, when the input data $D_1$ is set in the first flip-flop, the testing device 2 generates address signals $A_0$ through $A_m$, each of which indicates "0", so as to select the first flip-flop and, simultaneously, generates a scanning-in clock signal to the terminal SIC. Contrary to this, when the data $Q_1$ stored in the first flip-flop is output from the circuit 1, the testing device 2 generates address signals $A_0$ through $A_m$, each of which also indicates "0", so as to select the first flip-flop. The data of such signals transmitted from the testing device 2 are in advance formed in the test pattern file 4. That is, the CPU 3 searches test patterns stored in the file 4 and transmits the patterns to the testing device 2. Such test patterns will now be explained.

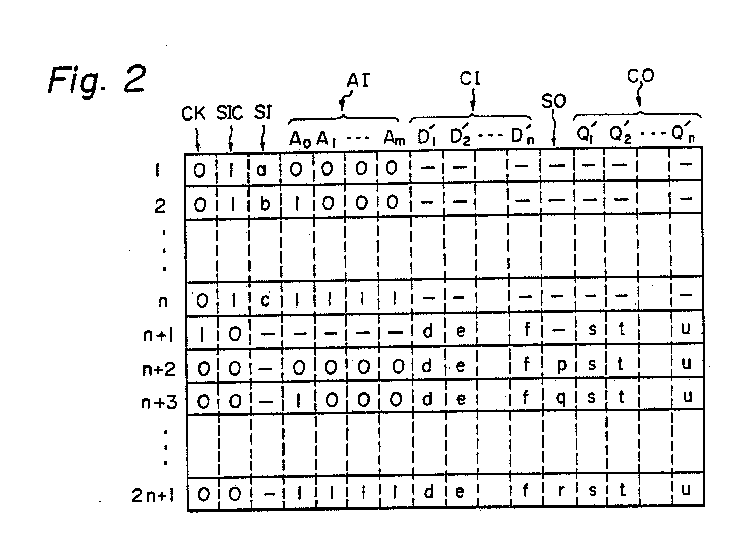

Fig. 2 is a diagram showing test patterns used in the system of Fig. 1. In Fig. 2, each of the test patterns is comprised of data used for the output terminals CK, SIC, SI, AI and CI and the output terminals SO and CO. The notations "a", "b", ..., "f" indicate input data whose values are "0" or "1", while "p", "q", ..., "u" indicate output data whose values are also "0" or "1". The notation "–" indicates input data or output data whose value is, however, meaningless. If the logic circuit 1 has n flip-flops, $(2n+1)$ test patterns are requried, which results in a large storage capacity of the test pattern file 4 being required. Among the test patterns, the first through n-th test patterns are used for a scanning-in operation in which input data is set in each of the flip-flops. In addition, the $(n+1)$th test patterns is used for transmitting the logic operation result of the combination circuit to the flip-flops. Further, $(n+2)$th through $(2n+1)$th test patterns are used for a scanning-out operation in which the data stored in each of the flip-flops is output. Therefore, there are $(2n+1)$ transmissions of test patterns between the logic circuit 1 and the testing device 2, which results in a long test executing time.

In the present invention, only one test pattern is prepared, so that the storage capacity of the test pattern file is reduced as compared with that of the conventional system. In addition, parallel input data of the test pattern is stored in a shift register, in parallel, which is newly provided between the logic circuit 1 and the testing device 2, and after that, each input data is transmitted sequentially from the shift register to the logic circuit. Contrary to this, serial output data of the logic circuit is transmitted sequentially to the shift register and after that, the data stored in the shift register is in parallel transmitted from the shift register to the testing device. Therefore, there are a small number of transmissions between the testing device 2 and the newly provided shift register (or the logic circuit 1), so that the speed of the test executing time becomes high compared with that of the conventional system. It should be noted that, the speed of the shift operation of the shift register is much higher than the speed of the transmission of test patterns.

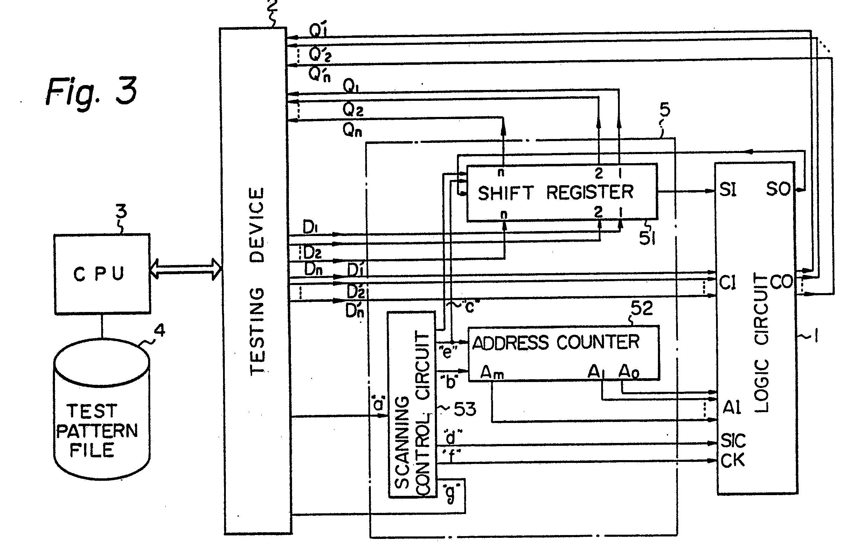

Fig. 3 is a block diagram illustrating an embodiment of the testing system for a logic circuit according to the present invention. In Fig. 3, the elements which are identical to those of Fig. 1 are denoted by the same references. In Fig. 3, another testing device 5, which is comprised of a shift register 51, an address counter 52 and a scanning control circuit 53, is provided, in addition to the system of Fig. 1. In the shift register 51, the data $D_1$, $D_2$, ..., $D_n$ is set therein in parallel, while data $Q_1$, $Q_2$, ..., $Q_n$ is output therefrom in parallel. Therefore, there are only two transmissions of a test pattern between the testing device 2 and the additional testing device 5, so that the test executing time becomes short. The address counter 52 selects one of the flip-flops (not shown) of the logic circuit 1. Both of the shift register 51 and the address counter 52 are controlled by the scanning control circuit 53.

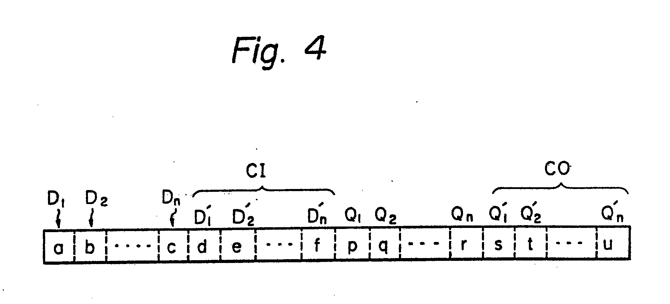

Fig. 4 is a diagram showing a test pattern used in the system of Fig. 3. As illustrated in Fig. 4, the test pattern is comprised of input data $D_1$, $D_2$, ..., $D_n$, constant input data $D'_1$, $D'_2$ ..., $D'_n$, output data $Q_1$, $Q_2$, ..., $Q_n$ and constant output data $Q'_1$, $Q'_2$, ..., $Q'_n$. That is, the address data $A_0$, $A_1$, ..., $A_m$ of Fig. 2 is not present in Fig. 4, since the address counter 52 generates such address data. In addition, the data used for the terminals CK and SIC is also not present in Fig. 4, since the scanning control circuit 53 generates such data. Thus, the number of test patterns prepared for a logic test is small.

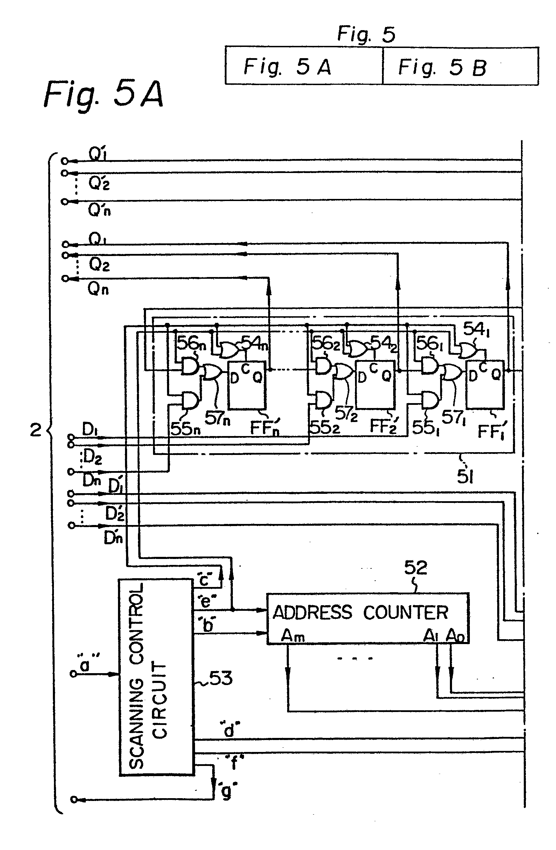

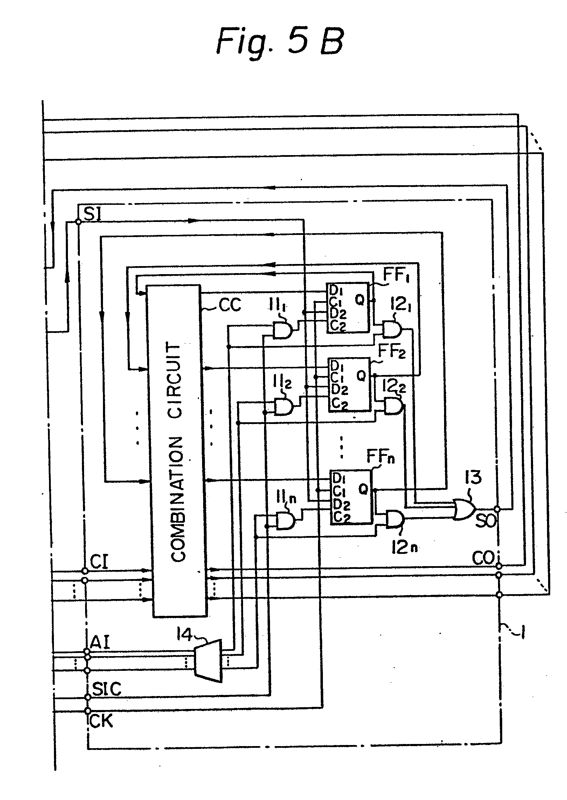

Fig. 5A and B is a detailed circuit diagram of the logic circuit 1 and the testing device 5 of Fig. 3. In Fig. 5, the logic circuit 1 comprises flip-flops $FF_1$, $FF_2$, ..., $FF_n$ and a combination circuit CC including other logic gates, such as AND gates, OR gates, inverters or the like. The flip-flops $FF_1$, $FF_2$, ..., $FF_n$ are provided with AND gates $11_1$, $11_2$, ..., $11_n$, respectively, and AND gates $12_1$, $12_2$, ..., $12_n$, respectively, which are connected to an OR gate 13. The shift register 51 comprises flip-flops $FF'_1$, $FF'_2$, ..., $FF'_n$ whose number is the same as the flip-flops $FF_1$, $FF_2$, ..., $FF_n$ of the logic circuit 1. Each of the flip-flops $FF'_i$ (i=1, 2, ..., n) is provided with an OR gate $54_i$ connected to a clock terminal thereof, an AND gate $55_i$ for inputting data $D_i$ thereto, an AND gate $56_i$ for a shift operation mode and an OR gate $57_i$ connected to the outputs of the AND gates $55_i$ and $56_i$.

The operation of the circuit of Fig. 5 will now be explained.

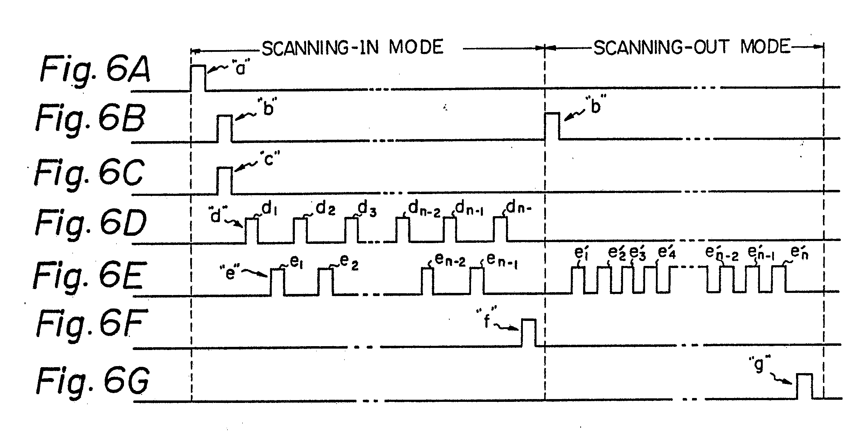

Figs. 6A through 6G are timing diagrams of the signal "a" through "g" appearing in the circuit of Fig. 5. Referring to Figs. 6A through 6G, the scanning control circuit 53 receives a scanning start signal "a", as illustrated in Fig. 6A, from the testing device 2 and, in turn, generates the following signals sequentially.

A clear signal "b" for clearing the address counter 52.

A parallel input indicating signal "c" for inputting input data $D_1$, $D_2$, ..., $D_n$ in parallel to the shift register 51.

A scanning-in clock signal "d" for setting the data stored in the high order flip-flop $FF'_1$ in a selected flip-flop of the logic circuit 1.

A shifting/counting signal "e" for shifting the shift register 51 and, simultaneously, advancing the address counter 52.

A clock signal "f" for setting the operation results of the combination circuit CC in all the flip-flops $FF_1$, $FF_2$, ..., $FF_n$ once at a time.

A scanning end signal "g" for indicating an end of the scanning-in and scanning-out operation.

The scanning-in operation in which each data $D_1$, $D_2$, ..., $D_n$ is set in ach of the flip-flops $FF_1$, $FF_2$, ..., $FF_n$ of the logic circuit 1, respectively, is carried out as follows. The scanning control circuit 53 generates a clear signal "b", as illustrated in Fig. 6B, so as to clear the address counter 52 and, simultaneously, generates a parallel input signal "c", as illustrated in Fig. 6C, to all the OR gates $54_1$, $54_2$, ..., $54_n$ and the AND gates $55_1$, $55_2$, ..., $55_n$ and accordingly, the data $D_1$, $D_2$, ..., $D_n$ is set in the flip-flops $FF'_1$, $FF'_2$, ..., $FF'_n$ in parallel.

Next, the scanning control circuit 53 generates a first pulse $d_1$ of a scanning-in clock signal "d", as illustrated in Fig. 6D, to all the AND gates $11_1$, $11_2$, ..., $11_n$. In this case, the AND gate $11_1$ is selected by the decoder 14, since the address data $A_0$, $A_1$, ..., $A_m$ of the address counter 52 indicates "0". Therefore, the data $D_1$ stored in the flip-flop $FF'_1$ is transmitted to the flip-flop $FF_1$ of the logic circuit 1. After that, the scanning control circuit 53 generates a first pulse $e_1$ of a shifting/counting signal "e", as illustrated in Fig. 6E, to all the OR gates $54_1$, $54_2$, ..., $54_n$ and the AND gates $56_1$, $56_2$, ..., $56_n$. Consequently, the data $D_2$, $D_3$, ..., $D_n$ stored in the flip-flops $FF'_2$, $FF'_3$, ..., $FF'_n$ is transmitted to the flip-flops $FF'_1$, $FF'_2$, ..., $FF'_{n-1}$, respectively, and in addition, the data stored in the flip-flop $FF_1$ of the logic circuit 1 is transmitted to the flip-flop $FF'_n$. Simultaneously, the address counter 52 is advanced, so that the address data $A_0$, $A_1$, ..., $A_m$ becomes "1, 0, ..., 0" (=2) and, accordingly, the flip-flop $FF_2$ of the logic circuit 1 is selected by the decoder 14.

Next, the scanning control circuit 53 generates a second pulse $d_2$ of the scanning-in clock signal "d" and the data $D_2$ stored in the flip-flop $FF'_1$ is transmitted to the flip-flop $FF_2$ of the logiOcircuit 1. After that, the scanning control circuit 53 generates a second pulse $e_2$ of the shifting/counting signal "e", so that the data $D_3$,

$D_4$, ..., $D_n$ stored in the flip-flop $FF'_2$, $FF'_3$, ...., $FF'_{n-1}$ is transmitted to the flip-flop $FF'_1$, $FF'_2$, ..., $FF'_{n-2}$, respectively, and in addition, the data stored in the flip-flop $FF_2$ of the logic circuit 1 is transmitted to the flip-flop $FF'_n$. Simultaneously, the address counter 52 is advanced. Thus, after the scanning control circuit 53 has generated all the pulses $d_1$, $d_2$, ..., $d_n$; $e_1$, $e_2$, ..., $e_{n-1}$, all the data $D_1$, $D_2$, ..., $D_n$ is set in the flip-flops $FF_1$, $FF_2$, ..., $FF_n$, respectively, of the logic circuit 1.

For such data $D_1$, $D_2$, ..., $D_n$ stored in the flip-flops $FF_1$, $FF_2$, ..., $FF_n$, respectively, the logic operation is executed by the combination circuit CC. After that, the scanning control circuit 53 generates a clock signal "f", as illustrated in Fig. 6F, so that the operation results $Q_1$, $Q_2$, ..., $Q_n$ of the combination circuit CC are set in each of the flip-flops $FF_1$, $FF_2$, ..., $FF_n$, respectively, in parallel.

The scanning-out operation in which the operation results $Q_1$, $Q_2$, ..., $Q_n$ stored in the flip-flops $FF_1$, $FF_2$, ..., $FF_n$ of the logic circuit 1 are transmitted to the testing device 2 will now be explained. In the scanning-out mode, the scanning control circuit 53 generates a clear signal "b" as illustrated in Fig. 6B, so that the address counter 52 is cleaned and the flip-flop $FF_1$ is selected by the decoder 14. Next, the scanning control circuit 53 generates a pulse $e'_1$ of the shifting/counting signal "e", as illustrated in Fig. 6E, and the data $Q_1$ stored in the flip-flop $FF_1$ is transmitted through the AND gate $12_1$ and the OR gate 13 to the flip-flop $FF'_n$. Simultaneously, the address counter 52 is advanced, so that the flip-flop $FF_2$ is selected by the decoder 14. Similarly, the scanning control circuit 53 generates a pulse $e'_2$, the data $Q_1$ stored in the flip-flop $FF'_n$ is transmitted to the flip-flop $FF'_{n-1}$ and the data stored in the flip-flop $FF_2$ of the logic circuit 1 is transmitted to the flip-flop $FF'_n$. Thus, after the scanning control circuit 53 has generated all the pulses $e'_1$, $e'_2$, ..., $e'_n$, all the operation results $Q_1$, $Q_2$, ..., $Q_n$ are set in the flip-flops $FF'_1$, $FF'_2$, ..., $FF'_n$, respectively, of the shift register 51.

Next, the scanning control circuit 53 generates a scanning end signal "g", as illustrated in Fig. 6G, to the testing device 2, and the testing device 2 receives the operation results $Q_1$, $Q_2$, ..., $Q_n$ stored in the flip-flops $FF'_1$, $FF'_2$, ..., $FF'_n$ in parallel. As a result, one test for the logic circuit 1 is completed.

In Figs. 3 and 5, the additional testing device 5 according to the present invention is provided between the testing device 2 and the logic circuit 1. However, it should be noted that the additional testing device 5 can be incorporated in the testing device 2.

As explained hereinbefore, the testing system according to the present invention has the following advantages as compared with those of the conventional system.

(1) The capacity of the test pattern file 4 is reduced, since only a small number of test patterns are necessary.

(2) The test executing time is reduced, since there are only a small number of transmissions of test patterns between the testing device 2 and the logic circuit 1.

**Claims**

1. A method for testing by means of test data a logic circuit (1) which includes a plurality of flip-flops ($FF_1$, $FF_2$, ..., $FF_n$) associated with a scanning path between scanning-in and scanning-out terminals (SI, SO) of the logic circuit, and a combination circuit (CC) including logic gates, the method comprising the steps of:

loading input data ($D_1$, $D_2$, ..., $D_n$) forming the test data in parallel into a separate shift register (51);
reading out the input data from the shift register to the scanning-in terminal (SI) in serial form;
sequentially setting the bits of the input data in serial form in each of the flip-flops, respectively;
performing a logic operation upon the input data set in the flip-flops by applying these data to the combination circuit and providing, as a result, output data ($Q_1$, $Q_2$, ..., $Q_n$);
setting the output data resulting from the logic operation in the flip-flops in parallel;
sequentially feeding back the output data of the flip-flops from the scanning-out terminal (SO) in serial form to the shift register; and
outputting the output data ($Q_1$, $Q_2$, ..., $Q_n$) in parallel form from the shift register.

2. A device for testing by means of test data a logic circuit (1) which includes a plurality of first flip-flops ($FF_1$, $FF_2$, ..., $FF_n$) associated with a scanning path between scanning-in and scanning-out terminals (SI, SO) of the logic circuit, and a combination circuit (CC) including logic gates, the device comprising an addressing means (52) for sequentially selecting each of the first flip-flops and being characterised by:

a shift register (51) connected to the scanning-in and scanning-out terminals, said shift register begin adapted (i) to receive input data ($D_1$, $D_2$, ..., $D_n$) forming said test data in parallel, (ii) to transmit sequentially the bits of the input data in serial form through the scanning-in terminal to each selected one of the first flip-flops, (iii) to receive sequentially through the scanning-out terminal output data ($Q_1$, $Q_2$, ..., $Q_n$) set into the first flip-flops by the combination circuit, the output data resulting from the operation of the combination circuit on the input data previously stored in each selected one of the first flip-flops, and (iv) to output the output data ($Q_1$, $Q_2$, ..., $Q_n$) in parallel form, the shift register comprising a plurality of second flip-flops ($FF'_1$, $FF'_2$, ..., $FF'_n$), connected in series, the number of which is the same as the number of the first flip-flops of the logic circuit; and

means (53) for controlling the addressing means (52) and the shift register (51), the controlling means generating:

a clear signal ("b") for clearing the addressing means;

a parallel input indicating ("c") signal for inputting the input data in parallel to the shift register;

a scanning-in clock signal ("d") for transmitting one of the input data bits stored in a high order one of the second flip-flops to a selected one of the first flip-flops;

a shifting/counting signal ("e") for shifting the shift register and advancing the addressing means;

a clock signal ("f") for setting the operation result of the combination circuit in the first flip-flops in parallel; and

a scanning end signal ("g") for indicating an end of test operation.

## Patentansprüche

1. Verfahren zum Testen, mit Hilfe von Testdaten, einer logischen Schaltung (1), welche eine Anzahl von Flipflops (FF$_1$, FF$_2$, ..., FF$_n$), die einem Abtastweg zwischen Abtast-Eingangs- und Abtast-Ausgangsanschlüssen (SI, SO) der logischen Schaltung zugeordnet sind, und eine Kombinationsschaltung (CC) umfaßt, welche logische Verknüpfungsglieder aufweist, mit den folgenden Verfahrensschritten:

paralleles Laden der Eingangsdaten (D$_1$, D$_2$, ..., D$_n$), welche die Testdaten bilden, in ein separates Schieberegister (51),

Auslesen der Eingangsdaten von dem Schieberegister zu dem Abtast-Eingangsanschluß (SI) in serieller Form,

sequentielles Setzen der Bits der Eingangsdaten in serieller Form in jedem der entsprechenden Flipflops,

Durchführen einer logischen Operation mit den in den Flipflops gesetzten Eingangsdaten durch Zuführen dieser Daten zu der Kombinationsschaltung und durch Lieferung der Ausgangsdaten (Q$_1$, Q$_2$, ... Q$_n$) als Ergebnis,

paralleles Setzen der Ausgangsdaten, welche aus der logischen Operation resultieren, in den Flipflops,

sequentielles Rückführen der Ausgangsdaten der Flipflops von dem Abtast-Ausgangsanschluß (SO) in serieller Form zu dem Schieberegister, und

Ausgabe der Ausgangsdaten (Q$_1$, Q$_2$, ... Q$_n$) von dem Schieberegister in paralleler Form.

2. Vorrichtung zum Testen, mit Hilfe von Testdaten, einer logischen Schaltung (1), welche eine Anzahl von ersten Flipflops (FF$_1$, FF$_2$, ... FF$_n$), die einem Abtastweg zwischen Abtast-Eingangs- und Abtast-Ausgangsanschlüssen (SI, SO) der logischen Schaltung zugeordnet sind, und eine Kombinationsschaltung (CC) umfaßt, welche logische Verknüpfungsglieder umfaßt, mit einer Adressiereinrichtung (52) zur sequentiellen Auswahl jedes der ersten Flipflops, gekennzeichnet durch:

ein Schieberegister (51), das mit den Abtast-Eingangs- und den Abtast-Ausgangsanschlüssen verbunden und ausgebildet ist: (I) Eingangsdaten (D$_1$, D$_2$, ... D$_n$), welche die Testdaten bilden, parallel zu empfangen, (II) die Bits der Eingangsdaten in serieller Form durch den Abtast-Eingangsanschluß zu jedem ausgewählten der ersten Flipflops zu übertragen, (III) über den Abtast-Ausgangsanschluß sequentiell Ausgangsdaten (Q$_1$, Q$_2$, ... Q$_n$) zu empfangen, welche durch die Kombinationsschaltung in den ersten Flipflops gesetzt sind und welche aus dem Betrieb der Kombinationsschaltung mit den zuvor in jedem ausgewählten der ersten Flipflops gesetzten Eingangsdaten resultieren, und (IV) die empfangenen Daten (Q$_1$, Q$_2$, ... Q$_n$) in paralleler Form auszugeben, wobei das Schieberegister eine Anzahl von zweiten Flipflops (FF$_1'$, FF$_2'$, ..., FF$_n'$) umfaßt, welche in Reihe geschaltet sind, und deren Anzahl gleich der Anzahl der ersten Flipflops der logischen Schaltung ist, und

Einrichtung (53) zur Steuerung der Adressiereinrichtung (52) und des Schieberegisters (51), welche erzeugen:

ein Löschsignal ("b") zum Löschen der Adressiereinrichtung,

ein die parallele Eingabe anzeigendes Signal ("c") zur parallelen Eingabe der Eingangsdaten in das Schieberegister,

ein Abtast-Eingangs-Taktsignal ("d") zur Übertragung eines der Eingabedatenbits, welches in einem Flipflop hoher Ordnung der zweiten Flipflops gespeichert ist zu einem ausgewählten der ersten Flipflops,

ein Verschiebe/Zählsignal ("e") zur Verschiebung des Schieberegisters und Vorrücken der Adressiereinrichtung,

eine Taktsignal ("f") zum parallelen Setzen des Operationsergebnisses der Kobinationsschaltung in den ersten Flipflops, und

ein Abtastendsignal ("g") zur Anzeige eines Endes eines Testbetriebs.

## Revendications

1. Procédé permettant d'essayer au moyen d'une donnée d'essai un circuit logique (1) qui comporte plusieurs bascules (FF$_1$, FF$_2$, ..., FF$_n$) associées à un trajet d'exploration se trouvant entre des bornes d'entrée d'exploration et de sortie d'exploration (SI, SO) du circuit logique et un circuit de combinaison (CC) comportant des portes logiques, le procédé comprenant les opérations suivantes:

charger une donnée d'entrée (D$_1$, D$_2$, ..., D$_n$) formant la donnée d'essai en parallèle dans un registre à décalage séparé (51); extraire la donnée d'entrée du registre à décalage en la faisant passer sur la borne d'entrée d'exploration (SI) sour forme série; positionner séquentiellement les bits de la donnée d'entrée sous forme série dans chacune des bascules respectivement;

effectuer une opération logique sur la donnée d'entrée positionnée dans les bascules en appliquant cette donnée au circuit de combinaison et produire, en résultat, une donnée de sortie $(Q_1, Q_2, ..., Q_n)$;

positionner la donnée de sortie résultant de l'opération logique dans les bascules en parallèle;

renvoyer séquentiellement la donnée de sortie des bascules au registre à décalage sous forme série depuis la borne de sortie d'exploration (SO); et

faire sortir du registre à décalage sous forme parallèle la donnée de sortie $(Q_1, Q_2, ..., Q_n)$.

2. Dispositif permettant d'essayer au moyen d'une donnée d'essai un circuit logique (1) qui comporte plusieurs premières bascules $(FF_1, FF_2, ..., FF_n)$ associées à un trajet d'exploration se trouvant entre des bornes d'entrée d'exploration et de sortie d'exploration (SI, SO) du circuit logique et un circuit de combinaison (CC) comportant des portes logiques, le dispositif comprenant un moyen d'adressage (52) permettant de sélectionner séquentiellement chacune des premières bascules, et étant caractérisé par un registré à décalage (51) connecté aux bornes d'entrée d'exploration et de sortie d'exploration, ledit registre à décalage étant conçu:

(i) pour recevoir une donnée d'entrée $(D_1, D_2, ..., D_n)$ formant ladite donnée d'essai en parallèle, (ii) pour transmettre séquentiellement les bits de la donnée d'entrée sous forme série, via la borne d'entrée d'exploration, à chacune, sélectionnée, es premières bascules, (iii) pour recevoir séquentiellement, via la borne de sortie d'exploration, la donnée de sortie $(Q_1, Q_2, ..., Q_n)$ positionnée dans les premières bascules par le circuit de combinaison, la donnée de sortie résultant de l'opération effectuée par le circuit de combinaison sur la donnée d'entrée précédemment emmagasinée dans chacune, sélectionnée, des premières bascules, et (iv) pour produire la donnée reçue $(Q_1, Q_2, ..., Q_n)$ sous forme parallèle, le registre à décalage comprenant plusieurs deuxièmes bascules $(FF'_1, FF'_2, ..., FF'_n)$ connectées en série dont le nombre est identique à celui des premières bascules du circuit logique; et

un moyen (53) permettant de commander le moyen d'adressage (52) et le registre à décalage (51), le moyen de commande produisant:

un signal d'effacement ("b") permettant d'effacer le moyen d'adressage;

un signal ("c") d'indication d'entrée en parallèle permettant de faire entrer la donnée d'entrée en parallèle dans le registre à décalage;

un signal ("d") de cadencement d'entrée d'exploration permettant de transmettre un des bits de la donnée d'entrée emmagasinés dans l'une d'ordre élevée, des deuxièmes bascules à l'une, sélectionnée, des premières bascules;

un signal ("e") de décalage-comptage permettant de décaler le registre à décalage et de faire avancer le moyen d'adressage;

un signal de cadencement ("e") permettant de positionner le résultat de l'opération effectuée par le circuit de combinaison dans les premières bascules en parallèle; et

un signal ("g") de fin d'exploration permettant d'indiquer une fin d'opération d'essai.

Fig. 1

2

$Q'_1 \sim Q'_n$

$Q_i\ (i=1-n)$

$D_i\ (i=1-n)$      SI     SO

$D'_1 \sim D'_n$      CI     CO

$A_0 \sim A_m$      AI

SIC

CK

LOGIC CIRCUIT

~1

3

CPU

TESTING DEVICE

4

TEST PATTERN FILE

0 023 419

Fig. 2

| | CK | SIC | SI | $A_0$ | $A_1$ | $\cdots$ | $A_m$ | $D'_1$ | $D'_2$ | $\cdots$ | $D'_n$ | SO | $Q'_1$ | $Q'_2$ | $\cdots$ | $Q'_n$ |
|---|---|---|---|---|---|---|---|---|---|---|---|---|---|---|---|---|
| | | | | $\overbrace{\qquad}^{AI}$ | | | | $\overbrace{\qquad}^{CI}$ | | | | | $\overbrace{\qquad}^{CO}$ | | | |
| 1 | 0 | 1 | a | 0 | 0 | 0 | 0 | – | – | | – | – | – | – | | – |
| 2 | 0 | 1 | b | 1 | 0 | 0 | 0 | – | – | | – | – | – | – | | – |
| $\cdots$ | | | | | | | | | | | | | | | | |
| n | 0 | 1 | c | 1 | 1 | 1 | 1 | – | – | | – | – | – | – | | – |
| n+1 | 1 | 0 | – | – | – | – | – | d | e | | f | – | s | t | | u |
| n+2 | 0 | 0 | – | 0 | 0 | 0 | 0 | d | e | | f | p | s | t | | u |
| n+3 | 0 | 0 | – | 1 | 0 | 0 | 0 | d | e | | f | q | s | t | | u |
| $\cdots$ | | | | | | | | | | | | | | | | |
| 2n+1 | 0 | 0 | – | 1 | 1 | 1 | 1 | d | e | | f | r | s | t | | u |

0 023 419

Fig. 3

0 023 419

# Fig. 4

Fig. 5

| Fig. 5 A | Fig. 5 B |

Fig. 5A

# Fig. 5 B

Fig. 6A  Fig. 6B  Fig. 6C  Fig. 6D  Fig. 6E  Fig. 6F  Fig. 6G